# EUROPEAN PATENT APPLICATION

(11) **EP 3 486 669 A1**
(43) Date of publication of application: **22.05.2019**
(21) Application number: 17202539.7
(22) Date of filing: 20.11.2017
(51) Int. Cl.: G01R 33/28, G01R 33/36, G01R 33/54

(54) **METHOD OF OPERATING A GANTRY DISPLAY OF A MAGNECTIC RESONANCE EXAMINATION SYSTEM TO REDUCE ELECTROMAGNETIC INTERFERENCE**

(71) Applicant: Koninklijke Philips N.V., 5656 AE Eindhoven (NL)
(72) Inventor: HAM, Cornelis Leonardus Gerardus, 5656 AE Eindhoven (NL); BACHYNSKYY, Sergiy, 5656 AE Eindhoven (NL)
(74) Representative: de Haan, Poul Erik

(57) **Abstract**

The invention relates to a gantry display (2, 2') of a magnetic resonance examination system (1, 1'). According to the invention, the gantry display (2, 2') comprises a screen (9, 9') for displaying at least magnetic resonance examination workflow information, and the method comprises the following steps:
- providing information to the gantry display (2, 2') in real time whether or not a magnetic resonance scan is in operation,
- receiving this information by the gantry display (2, 2') in real time,
- displaying on the screen (9, 9') of the gantry display (2, 2') magnetic resonance examination workflow information at least during part of the time when the gantry display (2, 2') receives such information that no magnetic resonance scan is under operation, and
- switching the screen (9, 9') of the gantry display to idle mode any time when the gantry display (2, 2') receives such information that a magnetic resonance scan is under operation. In this way an easy, an efficient and inexpensive possibility of using a gantry display (2, 2') for magnetic resonance examination applications is provided.

## Description

### FIELD OF THE INVENTION

The invention relates to the field of magnetic resonance (MR) examination systems and in particular to a method for operating a gantry display of a magnetic resonance examination system and to a magnetic resonance examination system with a control unit for controlling magnetic resonance scans of the magnetic resonance examination system and a gantry display for displaying at least workflow information for the magnetic resonance examination system.

### BACKGROUND OF THE INVENTION

Magnetic Resonance technicians are requiring ever increasing diagnostic details and enhanced monitoring information on patient monitoring devices. MR monitoring is becoming more common, and responding to patient needs is becoming more critical. The need for this increase in patient information combined with improvements in display and touch panel technology has moved the industry toward larger displays and improved interfaces.

Monitors and other devices that are used as gantry displays for a magnetic resonance examination system typically must be operated by clinicians wearing gloves. Therefore, in the MR environment, various types of touchscreen user interface displays cannot be used. In addition, the MR environment, however, in general requires substantial shielding on the displays used, due to the extremely high levels of EMI across the frequency spectrum. Furthermore, EMI noise emitted from and through these screens by internal display noise sources must be extremely low to avoid negatively impacting operations of magnetic resonance imaging (MRI) system. That is, the use of resistive touch technology in combination with stringent EMI requirements results in a difficult EMI shielding design due to the location of the active elements of the touch technology. Accordingly, as the MRI system functions by sensing the electrical waves generated by the reorientation of atoms within the body, any significant source of EMI in the room while the MRI system is running will cause degradation of the image produced by the MRI system.

Typically, on the small displays currently in use, stainless steel meshes are utilized to achieve adequate shielding. This stainless steel shielding results in high light loss. No secondary shield layer is required in these applications. Scale up of these designs is not possible as the loss generated by the screen can drop by 30 db, resulting in insufficient screening, i.e., EMI leakage. Furthermore, these small screens also have lower EMI gasketing requirement than larger screens. In addition, displays, particularly such small displays, require a separate environmental seal that requires a bezel, i.e., an edge seal is not possible with this design. The presence of such a required bezel hinders effective cleaning procedures in the healthcare setting. In addition to the foregoing, transmitted noise, i.e., EMI, is a function of the sum of all individual openings. This sum increases with the square of screen size.

Previous approaches to shielding displays for EMI use sheets ofprotective material that rely on individual wires to terminate the shield to the housing. Unfortunately, this level oftermination does not produce the sufficient shielding for an MRI environment. Thus, current touchscreen displays are small devices that are expensive and difficult to produce.

These problems are addressed by the teaching described in US 2016/0320463 A1. From this document, a magnetic resonance safe touchscreen display is known which includes a touchscreen and a film that has a high frequency shielding layer and a low frequency shielding layer. A bus bar conductively couples the low frequency shielding layer to the high frequency shielding layer around a perimeter of a face of the film and the edge of the film. The film is adjacent to a rear face of the touchscreen. The bus bar facilitates the connection of the touchscreen and layers to the display to form a Faraday cage around the display components contained within the display housing. Though such a design may be highly effective it is still more costly than using a conventional touchscreen display. Further to the fact that shielding is costly, it will reduce the brightness and the viewing angle of the screen and affects the touch-sensitivity.

### SUMMARY OF THE INVENTION

It is an object of the invention to provide an easy, efficient and inexpensive possibility of using a gantry display for magnetic resonance examination applications.

According to the invention, this object is addressed by the subject matter of the independent claims. Preferred embodiments of the invention are described in the sub claims.

Therefore, according to the invention, a method for operating a gantry display of a magnetic resonance examination system is provided, the gantry display comprising a screen for displaying at least magnetic resonance examination workflow information, the method comprising the following steps:
- providing information to the gantry display in real time whether or not a magnetic resonance scan is in operation,
- receiving this information by the gantry display in real time,
- displaying on the screen of the gantry display magnetic resonance examination workflow information at least during part of the time when the gantry display receives such information that no magnetic resonance scan is under operation, and
- switching the screen of the gantry display to idle mode any time when the gantry display receives such information that a magnetic resonance scan is under operation.

Thus, it is an essential issue of the invention the screen is switched on or off, respectively, depending whether or not a magnetic resonance scan is in operation. A magnetic resonance scan being in operation means in the context of the present invention that image data is acquired. However, the invention does not require to leave the idle mode any time that no magnetic resonance scan is in operation. Therefore, as set out further below, in case of consecutive imaging sequences, the invention allows to stay in idle mode between the sequences or to go back to active mode. Switching the screen off, i.e. switching the screen to idle mode at least means that screen is not supplied with electric energy for the idle time any more. Therefore, during idle time, electric currents which are due to the electric supply are avoided which means that electromagnetic shielding of the display is not necessary. Operation of the display during times when no magnetic resonance scans are in operation do not mean a problem with respect to the fact that there is no shielding of the display since no interference may occur and, thus, no spurious signals that may generate artifacts and/or noise in the MR images are to be expected. In other words: According to the invention, the screen of the gantry display is automatically switched off during scanning. In that case it does not need to be shielded.
Wherever "stop during the scan" is mentioned in the above listed options, the 'off' status can be implemented in a simple or an advanced way, in terms of time and the way its spurious emission is stopped.

With respect to the idle mode, according to a preferred embodiment of the invention, the display may be off during the entire examination. Alternatively, the display may be off during the each scan within an examination, but may be on in between scans. Further to the display being off during the each scan and being on in between scans, according to a preferred embodiment of the invention, the screen may also be on during pauses during a scan like between breath holds of a patient under examination. According to a preferred embodiment of the invention, the screen may be off during MR signal reception within a scan, but may be on during the rest of the scan.

The state "off" means that the screen goes into a halt state. The data before the halt state may be stored for later recovery. According to a preferred embodiment of the invention, e-ink like technology is used to keep display displaying information without refreshing.

Therefore, according to a preferred embodiment of the invention, the method comprises the following step:
- not refreshing the display information of the screen during idle mode or not displaying any display information on the screen during idle mode at all. In this respect, it is further preferred that the method comprises the following step:
- storing the display information before switching to idle mode.

In general, the gantry display may be controlled by an external unit like a control unit for controlling the magnetic resonance scans of the magnetic resonance examination system. In such a case, the gantry display is not required to be equipped with its own processor. However, if the gantry display is equipped with its own processor, according to the methods described above, while the screen itself does not required a shielding any more the processor would have to shielded since it would also run during magnetic resonance scan times.

Therefore, according to a preferred embodiment of the invention, if the gantry display comprising a processor, the method comprises the following steps:
- switching the processor of the gantry display to active mode at least part of the time when the gantry display receives such information that no magnetic resonance scan is under operation, and
- switching the processor of the gantry display to idle mode any time when the gantry display receives such information that a magnetic resonance scan is under operation.

In this way, a shielding of the processor may also be avoided. With respect to "on" state and the "off" state (idle mode) of the processor respective preferred options apply as describe further above for the "on" and "off" states of the screen of the gantry display.

According to a preferred embodiment of the invention, the magnetic resonance examination system comprises a control unit for controlling magnetic resonance scans of the magnetic resonance examination system, and the method comprises the following steps:
- generating the information whether or not a magnetic resonance scan is under operation in the control unit, and
- sending this information from the control unit to the gantry display.

Further, according to a preferred embodiment of the invention, the screen comprises touch control ability, and the method comprises the following steps:
- switching the touch control ability of the gantry display to active mode at least part of the time when the gantry display receives such information that no magnetic resonance scan is under operation, and
- switching the touch control ability of the gantry display to idle mode any time when the gantry display receives such information that a magnetic resonance scan is under operation.

In this way, interferences with MR images due to electric currents because of touch ability of the screen maybe avoided, too.

Furthermore, according to a preferred embodiment of the invention, the magnetic resonance examination system comprises a magnetic resonance scanner with at least a magnet and RF coils, the magnetic resonance scanner being located in an examination room which comprises an electromagnetic shielding on its outer walls, and the method comprises the following step:
- using the gantry display for displaying workflow information in the examination room with no additional electromagnetic shielding between the magnetic resonance scanner and the gantry display. Such use becomes possible due to selectively controlling the "on" and "off" states of the gantry display, respectively, as described above.

The invention also relates to a non-transitory computer-readable medium for controlling the operation of a magnetic resonance examination system, the magnetic resonance examination system comprising a gantry display with a screen, the non-transitory computer-readable medium comprising instructions stored thereon, that when executed on a processor, perform the steps of any of the methods described above.

Further, the invention also relates to a magnetic resonance examination system with a control unit for controlling magnetic resonance scans of the magnetic resonance examination system and a gantry display for displaying at least workflow information for the magnetic resonance examination system, the gantry display comprising a screen, wherein the gantry display is coupled with the control unit in such a way that the screen is idle during magnetic resonance scans. In this respect, according to a preferred embodiment of the invention, the screen does not comprise an electromagnetic shielding.

Further, according to a preferred embodiment of the invention, the gantry display comprises a processor and the gantry display is coupled with the control unit in such a way that the processor is idle during magnetic resonance scans. With respect to this preferred embodiment of the invention, the processor preferably does not comprise an electromagnetic shielding.

It is to be understood the gantry display, the magnetic resonance examination system with a control unit for controlling magnetic resonance scans of the magnetic resonance examination system and a gantry display and the methods for operating the gantry display and/or the magnetic resonance examination system with a control unit for controlling magnetic resonance scans of the magnetic resonance examination system and the gantry display as described before may be combined in any possible way.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a magnetic resonance examination system according to the first preferred embodiment of the invention;
Fig. 2 depicts a flow chart of a method according to a first preferred embodiment of the invention;
Fig. 3 schematically depicts a magnetic resonance examination system according to the first preferred embodiment of the invention; and
Fig. 4 depicts a flow chart of a method according to a first preferred embodiment of the invention.

### DETAILED DESCRIPTION OF EMBODIMENTS

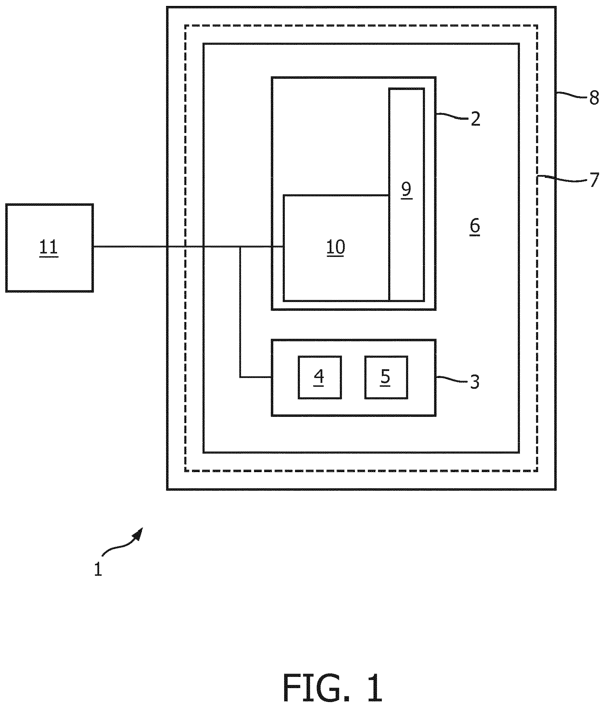

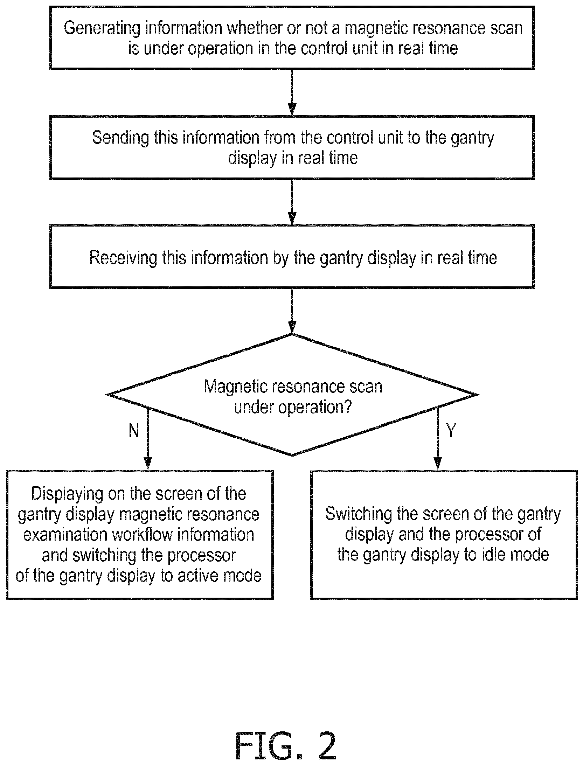

According to the first preferred embodiment of the invention, a magnetic resonance examination system 1 which is depicted in the Fig. 1 and a method for operating a gantry display 2 of this magnetic resonance examination system 1 as depicted in Fig. 2 are provided. Besides the gantry display 2 the magnetic resonance examination system 1 comprises a magnetic resonance scanner 3 with at least a magnet 4 and RF coils 5 wherein the gantry display 2 and the magnetic resonance scanner 3 are located in an examination room 6 which comprises an electromagnetic shielding 7 in its outer walls 8. The gantry display 2 comprises a screen 9 for displaying at least magnetic resonance examination workflow information and a processor 10 for controlling the screen 9. The magnetic resonance examination system 1 further comprises a control unit 11 for controlling magnetic resonance scans of the magnetic resonance examination system 1, wherein the control unit 11 is located outside the examination room.

The method according to the first preferred embodiment, as depicted in Fig. 2, is as follows:
First, information whether or not a magnetic resonance scan is under operation is generated in the control unit 11 in real time. Such information may be generated in the control unit without further ado since the magnetic resonance scanner 3 of the magnetic resonance examination system 1 is directly controlled by the control unit 11. Then this information is sent from the control unit 11 to the gantry display 2 in real time which means that this information is also received by the gantry display 2 in real time. Then it is checked whether this information comprises an indication whether or not a magnetic resonance scan is under operation. Depending on the outcome of this check, on the screen 9 of the gantry display 2 magnetic resonance examination workflow information is displayed and the processor 10 of the gantry display 2 is switched to active mode when the gantry display 2 receives such information that no magnetic resonance scan is under operation, or the screen 9 and the processor 10 of the gantry display 2 are both switched to idle mode when the information indicates that a magnetic resonance scan is under operation. In this way, neither the display 9 nor the processor 10 of the gantry display 2 needs to be shielded since no electrical currents for supplying the screen 9 or the processor 10 of the gantry display 2 occur during times when magnetic resonance scans are under operation. Therefore, degradation of MR images is avoided. It is to be noted that the control unit 11 is located outside the examination room 6 which means that due to the shielding 7 in the outer walls 8 of the examination room 6 no degradation of MR images acquired by the magnetic resonance scanner 3 may occur, either.

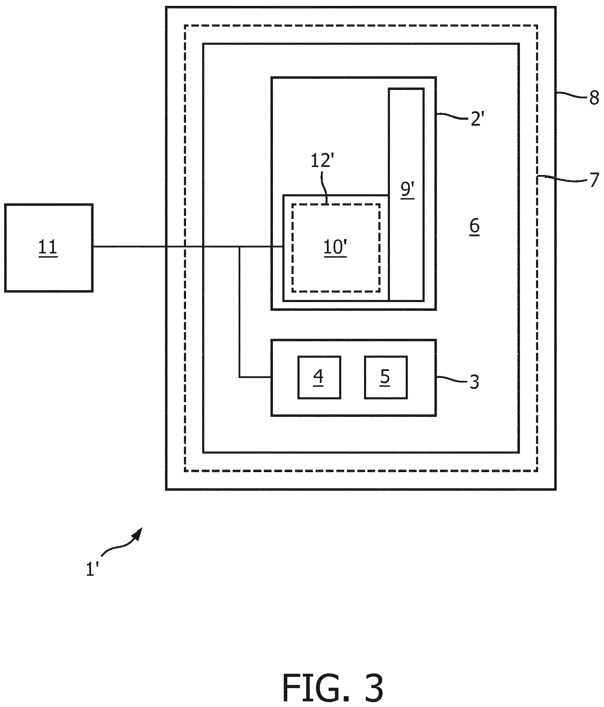

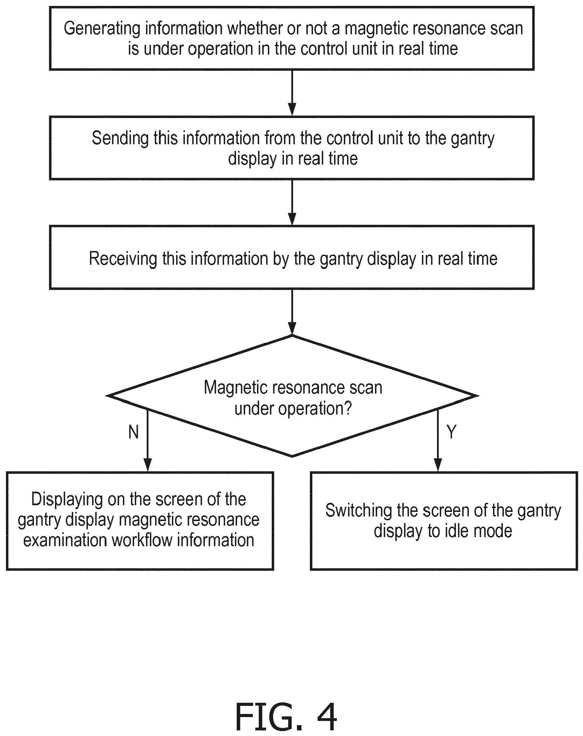

In contrast to the gantry display 2 according to the first preferred embodiment described above, the gantry display 2' according to the second preferred embodiment described in the following comprises a processor 10' with an electromagnetic shielding 12'. It is to be noted that within the context of the present invention, the term "porocessor" refers to any switching components that may continue working during scanning, like for instance a device for DC-DC conversion.Such a a processor 10' with an electromagnetic shielding 12' is schematically depicted in Fig. 3. As can be seen from Fig. 3, the rest of the magnetic resonance examination system 1' according to the second preferred embodiment is the same as for the magnetic resonance examination system 1 according to the first embodiment of the invention. Since the processor 10' comprises the electromagnetic shielding 12' mentioned before a slightliy different method maybe applied for the magnetic resonance examination system 1' according to the second preferred embodiment of the invention as described in the following with reference to Fig. 4:

In the same way as for the first preferred embodiment of the invention, first, information whether or not a magnetic resonance scan is under operation is generated in the control unit 11 in real time. Then this information is sent from the control unit 11 to the gantry display 2' in real time which means that this information is also received by the gantry display 2 in real time. In the next step it is checked whether this information comprises an indication whether or not a magnetic resonance scan is under operation. Depending on the outcome of this check, on the screen 9 of the gantry display 2 magnetic resonance examination workflow information is displayed when the gantry display 2 receives such information that no magnetic resonance scan is under operation, or the screen 9 of the gantry display 2 are both switched to idle mode when the information indicates that a magnetic resonance scan is under operation. Since the processor 10' of the gantry display 2' is shielded, the processor does not have to switch to idle mode during times when magnetic resonance scans are under operation. Actually, any possible degradation of MR images is already avoided because of the electromagnetic shielding 12' of the processor 10'.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| Magnetic resonance examination system | 1, 1' |
| Gantry display | 2,2' |
| Magnetic resonance scanner | 3 |
| Magnet | 4 |
| RF coils | 5 |
| Examination room | 6 |
| Electromagnetic shielding of the examination room | 7 |
| Outer walls | 8 |
| Screen | 9,9' |
| Processor | 10, 10' |
| Control unit | 11 |
| Electromagnetic shielding of processor | 12' |

## Claims

1. A method for operating a gantry display (2, 2') of a magnetic resonance examination system (1, 1'), the gantry display (2, 2') comprising a screen (9, 9') for displaying at least magnetic resonance examination workflow information, the method comprising the following steps:
- providing information to the gantry display (2, 2') in real time whether or not a magnetic resonance scan is in operation,
- receiving this information by the gantry display (2, 2') in real time,
- displaying on the screen (9, 9') of the gantry display (2, 2') magnetic resonance examination workflow information at least during part of the time when the gantry display (2, 2') receives such information that no magnetic resonance scan is under operation, and
- switching the screen (9, 9') of the gantry display to idle mode any time when the gantry display (2, 2') receives such information that a magnetic resonance scan is under operation.

2. The method according to claim 1, the method further comprising the following step:
- not refreshing display information of the screen (9, 9') during idle mode or not displaying any display information on the screen (9, 9') during idle mode at all.

3. The method according to claim 2, the method further comprising the following step:
- storing the display information before switching the screen (9, 9') to idle mode.

4. The method according to any of the previous claims, the gantry display (2) comprising a processor (10), the method further comprising the following steps:
- switching the processor (10) of the gantry display (2) to active mode at least part of the time when the gantry display (2) receives such information that no magnetic resonance scan is under operation, and
- switching the processor (10) of the gantry display (2) to idle mode any time when the gantry display (2) receives such information that a magnetic resonance scan is under operation.

5. The method according to any of the previous claims, the magnetic resonance examination system (1, 1') comprising a control unit for controlling magnetic resonance scans of the magnetic resonance examination system (1, 1'), the method comprising the following steps:
- generating the information whether or not a magnetic resonance scan is under operation in the control unit (11), and
- sending this information from the control unit (11) to the gantry display (2, 2').

6. The method according to any of the previous claims, the screen comprising touch control ability, the method comprising the following steps:
- switching the touch control ability of the gantry display (2, 2') to active mode at least part of the time when the gantry display (2, 2') receives such information that no magnetic resonance scan is under operation, and
- switching the touch control ability of the gantry display (2, 2') to idle mode any time when the gantry display (2, 2') receives such information that a magnetic resonance scan is under operation.

7. The method according to any of the previous claims, the magnetic resonance examination system (1, 1') comprising a magnetic resonance scanner (3) with at least a magnet (4) and RF coils (5), the magnetic resonance scanner (3) being located in an examination room (6) which comprises an electromagnetic shielding (7) in its outer walls (8), the method comprising the following step:
- using the gantry display (2, 2') for displaying workflow information in the examination room (6) with no additional electromagnetic shielding between the magnetic resonance scanner (3) and the gantry display (2, 2').

8. A non-transitory computer-readable medium for controlling the operation of a magnetic resonance examination system (1, 1'), the magnetic resonance examination system (1, 1') comprising a gantry display (2, 2') with a screen (9, 9'), the non-transitory computer-readable medium comprising instructions stored thereon, that when executed on a processor, perform the steps of any of the methods according to the previous claims.

9. A magnetic resonance examination system (1, 1') with a control unit (11) for controlling magnetic resonance scans of the magnetic resonance examination system (1, 1') and a gantry display (2, 2') for displaying at least workflow information for the magnetic resonance examination system (1, 1'), the gantry display (2, 2') comprising a screen (9, 9'), wherein the gantry display (2, 2') is coupled with the control unit (11) in such a way that the screen (9, 9') is idle during magnetic resonance scans.

10. The magnetic resonance examination system (1, 1') according to claim 1, wherein the screen (9, 9') does not comprise an electromagnetic shielding.

11. The magnetic resonance examination system (1) according to claim 9 or 10, wherein the gantry display (2) comprises a processor (10) and the gantry display (2) is coupled with the control unit (11) in such a way that the processor (10) is idle during magnetic resonance scans.

12. The magnetic resonance examination system (1) according to claim 11, wherein the processor (10) does not comprise an electromagnetic shielding.
